# EUROPÄISCHE PATENTSCHRIFT

(11) **EP 2 910 961 B1**
(45) Veröffentlichungstag und Bekanntmachung des Hinweises auf die Patenterteilung: **16.08.2017**
(21) Anmeldenummer: 15000524.7
(22) Anmeldetag: 24.02.2015
(51) Int. Cl.: G01R 31/34, H05C 1/04, G01R 31/06, G01R 31/28

(54) **Verfahren und Messaufbau zur Ermittlung von Wicklungsfehlern in Elektrogeräten**
Method and measurement setup for determining coil errors in electric appliances
Procédé et unité de mesure destinés à déterminer des erreurs de bobine dans des appareils électriques

(30) Priorität: 24.02.2014 DE 102014002388
(43) Veröffentlichungstag der Anmeldung: 26.08.2015
(73) Patentinhaber: GMC-I Gossen-Metrawatt GmbH, 90449 Nürnberg (DE)
(72) Erfinder: Pekar, Heinrich Michael, 90552 Röthenbach/Pegnitz (DE); Bernstein, Markus, 90574 Roßtal (DE); Styhler, Klaus, 90471 Nürnberg (DE)
(74) Vertreter: Kohl, Fabian Hanno

(56) Entgegenhaltungen:
- GB-A- 732 749
- JP-A- 2003 075 500
- US-A- 3 064 183

## Beschreibung

Die Erfindung betrifft ein Verfahren zur Ermittlung von Wicklungsfehlern in Elektrogeräten sowie einen Messaufbau zur Durchführung des Verfahrens.

Es ist bekannt, Wicklungen in Elektrogeräten nach der Wicklung zu überprüfen, um Wicklungsfehler aufzufinden.

Hierfür existieren spezielle Wicklungsprüfgeräte, die eigens für die Überprüfung von Wicklungen konzipiert sind. Eine entsprechende Vorrichtung mit einem Prüfverfahren geht aus der DE 197 26 394 A1 hervor.

Dort ist ein Prüfverfahren zur Erkennung von Isolationsschwachpunkten und Isolationsfehlern in Wicklungen beschrieben, bei der eine auf den Prüfling abgestimmte Kapazität verwendet wird. Dabei wird für jede Windung die Isolationsgüte separat bestimmt.

JP 2003 075500 A1 offenbart ein Verfahren und eine Vorrichtung zur Erfassung fehlerhafter Wicklungen eines Stators einer elektrischen Maschine. Die Vorrichtung umfasst ein der zu testenden Maschine entsprechendes Referenzobjekt. Verfahrensgemäß werden die bei Anlagen eines oder mehrerer Spannungsimpulse an der zu testenden Maschine und an dem Referenzobjekt erhaltenen Spannungs-Zeit-Verläufe miteinander verglichen, wobei Abweichungen einen fehlerhafte Wicklung in der zu testenden Maschine anzeigen.

US 3 064 183 A offenbart eine Prüfvorrichtung zur Prüfung von elektronischen Komponenten. Die Prüfvorrichtung umfasst eine Schaltfunkenstrecke.

GB 732 749 A offenbart einen Pulsgenerator für elektrische Zäune.

Es besteht Bedarf an einem Verfahren zur Ermittlung von Wicklungsfehlern in Elektrogeräten, das vereinfacht durchführbar ist und gegebenenfalls auch einen mobilen Einsatz vor Ort ermöglicht.

Diese Aufgabe wird durch ein Verfahren mit den Merkmalen des Anspruchs 1 gelöst. Vorteilhafte Weiterbildungen ergeben sich aus den Unteransprüchen.

Als Kern der Erfindung wird angesehen, dass aus einer Kapazität und einer Wicklung eines Elektrogeräts ein Schwingkreis gebildet wird, dessen Antwortsignal auf einen Spannungspuls ausgewertet wird.

Bei einem Elektrogerät kann es sich um einen Elektromotor, sowohl für Küchengeräte, Kraftfahrzeuge, usw., Aktuatoren, Sensorspulen, Ventile, Ablenkspulen, Transformatoren oder auch Elektromotoren handeln. Bevorzugt handelt es sich um einen Drehstrommotor.

Zur Feststellung eines Wicklungsfehlers, insbesondere eines Wicklungsschlusses, wird eine in einem Handmultimeter erzeugte Spannung an eine daran angekoppelte Impulseinheit mit einer Kapazität angelegt, wodurch die Kapazität geladen wird. Bei der Kapazität handelt es sich üblicherweise um einen Kondensator. Eine mit der Kapazität verbundene Schaltfunkenstrecke schaltet durch, sobald die Kondensatorspannung die Schaltspannung der Schaltfunkenstrecke übersteigt, wodurch ein Spannungsimpuls abgegeben wird.

Der am Ausgang der Impulseinheit befindliche Prüfling, also die Wicklung, bildet mit der Kapazität einen LC-Schwingkreis, der auf diesen Spannungsimpuls ein Antwortsignal generiert. Es ist dabei unerheblich, ob die Wicklung vor oder nach dem Anlegen der Spannung an die Impulseinheit angeschlossen wird. Bevorzugt ist allerdings, dass erst die Wicklung an den Ausgang der Impulseinheit angeschlossen wird und danach die Spannung angelegt wird. Bevorzugt wird eine Hochspannung bereitgestellt, also eine Spannung von 1000 V oder mehr.

Die Impulsentladung des LC-Schwingkreises ist das Antwortsignal, das erfasst und durch eine Zeitmessvorrichtung, die im Multimeter vorhanden ist, ausgewertet wird. Das zeitliche Verhalten des Antwortsignals ist dabei charakteristisch für die Anzahl und Lage der Windungen. Diese stellen dabei die Induktivität des LC-Schwingkreises dar. Als Parameter des Antwortsignals wird die Zeitdauer des ersten Schwingungsteils der Gesamtschwingung ermittelt. Dieser Wert wird angezeigt, oder ausgegeben oder auch gespeichert.

Um eine kostengünstige Messung durchführen zu können wird die Impulseinheit an das Multimeter angeschlossen. Dieses stellt die benötigte Spannung, auch 1 kV, bereit und wertet das Antwortsignal aus, also die Zeitdauer des ersten Schwingungsteils. Somit kann die Feststellung der Fehlerfreiheit einer Wicklung alleine mit einem Zusatzgerät in Form der Impulseinheit vorgenommen werden, wobei alle durch die Impulseinheit nicht bereit gestellten Funktionen bereits in einem üblicherweise vorhandenen Multimeter bereitgestellt werden, das für die Bereitstellung des Messverfahrens gewisse Grundvoraussetzungen bezüglich Ausgangsspannung und vergleichende Auswertungsmöglichkeiten mitbringen muss.

Misst man lediglich eine Wicklung, benötigt es Vorwissen, um ein Antwortsignal auswerten zu können. Daher besteht eine besonders vorteilhafte Weiterbildung darin, wenigstens zwei Wicklungen eines Elektrogeräts nacheinander auszumessen und die Zeitdauern zu vergleichen. Liegen diese weiter auseinander als ein vorgegebener Schwellwert, ist eine der Wicklungen fehlerhaft. Testet man drei Wicklungen bzw. deren ermittelte Zeitdauern gegeneinander, ist die Wahrscheinlichkeit, dass alle drei Wicklungen gleichsam defekt sind, extrem gering.

So erhält man auf einfache Art und Weise und insbesondere ohne Vorwissen eine Aussage darüber, ob alle Wicklungen eines Elektromotors fehlerfrei sind. Aussagen über die Art einzelner Windungsfehler der einzelnen Windungen können nicht getroffen werden, dafür ist das Verfahren schnell, flexibel und einfach durchzuführen.

Der Ausgang und der Eingang der Impulseinheit können dabei mehrere, bevorzugt zwei, Anschlüsse aufweisen. Der Eingang ist die Seite der Impulseinheit, die mit der Spannungsquelle, insbesondere dem Multimeter, verbunden ist, während der Ausgang mit dem Prüfling verbunden ist oder wird.

Die Spannung wird durchgehend angelegt, durch den Messaufbau werden periodisch Spannungsimpulse ausgegeben und Antwortsignale erzeugt. Die Antwortsignale einer Wicklung können entweder immer wieder unabhängig voneinander berechnet und ausgegeben werden, die ermittelten Zeitdauern können aber auch zu einem Mittelwert verrechnet werden. Eine Mittelwertbildung ist selbstverständlich nur mit den Messdaten einer Wicklung sinnvoll.

Die Auswerteeinheit kann insbesondere einen Komparator umfassen.

Im Folgenden wird die Erfindung anhand von Ausführungsbeispielen in Zeichnungsfiguren näher erläutert. Dabei zeigen:
- Fig. 1: einen Messaufbau mit Impulseinheit; und
- Fig. 2: einen Signalverlauf.

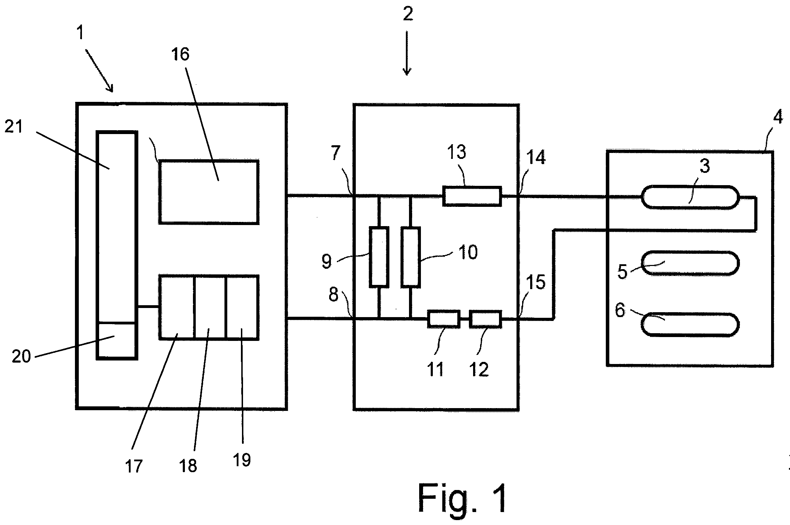

Fig. 1 zeigt einen Messaufbau umfassend ein Multimeter 1, eine Impulseinheit 2 und einen Prüfling in Form einer Wicklung 3 in einem Elektromotor 4.

Die weiteren Wicklungen 5 und 6 des Elektromotors 4 können nach der Untersuchung der Wicklung 3 geprüft werden.

Im Folgenden wird die Impulseinheit 2 näher beschrieben. Der Eingang der Impulseinheit 2 umfasst zwei Anschlüsse 7 und 8, mit denen die Impulseinheit 2 an das Multimeter 1 angeschlossen bzw. anschließbar ist. Der Kondensator 9 als Kapazität und der Entladewiderstand 10 sind parallel geschaltet, wobei der Entladewiderstand 10 auch als Personenschutz dient.

Mit dem Kondensator 9 ist eine Schaltfunkenstrecke 11 verbunden. Diese umfasst einen Entladeraum zwischen zwei Elektroden. Ist die Spannung zwischen den Elektroden größer als die Überschlagsspannung, wird ein zwischen den Elektroden befindliches Gas ionisiert und die Strecke wird kurzfristig kurzgeschlossen. So kann der Spannungsimpuls in den LC-Schwingkreis bestehend aus Impulseinheit 2 und Wicklung 3 induziert werden.

Weiterhin umfasst die Impulseinheit 2 eine Sicherung 12 und einen Schutzwiderstand 13 sowie die Anschlüsse 14 und 15 des Ausgangs.

Die Impulseinheit 2 ist somit einfach aufgebaut und daher sowohl transportabel als auch in Kombination mit einem geeigneten Multimeter 1 betreibbar.

Das Multimeter 1 umfasst eine Hochspannungsquelle 16, einen Spannungsmesspfad 17, einen Komparator 18, einen Prozessor 19, eine Auswerteeinheit 20 und eine Anzeige 21.

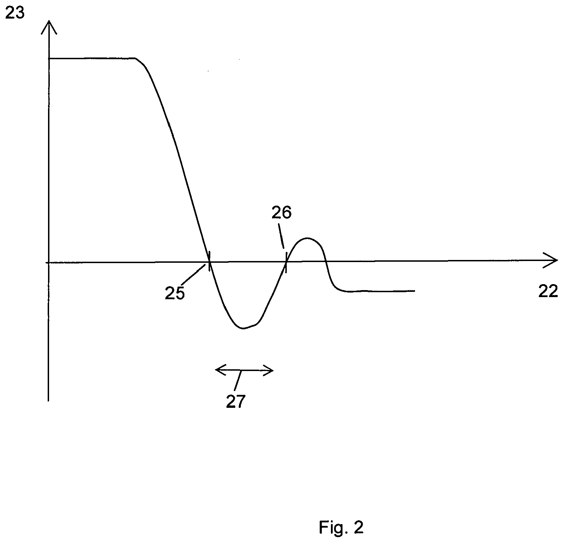

Das mit dem gezeigten Messaufbau erhaltbare und am Anschluss 15 abgreifbare Signal ist in Figur 2 dargestellt. Die Achse 22 zeigt dabei die Zeit und die Achse 23 die Signalspannung an. Die Kurve 24 repräsentiert das Signal. Die Kurve 24 besitzt mehrere Parameter wie die Anfangssignalspannung, den Zeitpunkt des ersten Nulldurchgangs, etc. Für Vergleichszwecke herangezogen wird jedoch bevorzugt die Zeitdauer des ersten negativen Schwingungsteils, der zwischen den Punkten 25 und 26 liegt. Es handelt sich also um die erste negative Teilschwingung.

Die Zeitdauer 27 ist ein Messwert im Bereich von einigen Mikrosekunden.

Um die Auswertung möglichst einfach zu gestalten ist das folgende Verfahren vorgesehen:

Als Prüfling wird eine erste Wicklung, bspw. die Wicklung 3, an der Impulseinheit 2 angeschlossen.

Am Multimeter 1 wird, bevorzugt mit zwei 1,5 V-Batterien, eine Hochspannung bis 1050 Vdc generiert. Diese Hochspannung lädt den Kondensator 9 auf. Überschreitet dessen Spannung die Überschlagsspannung der Schaltfunkenstrecke 11 schaltet diese durch. Dadurch wird auf den Ausgang der Impulseinheit 2 ein Spannungsimpuls gegeben.

Die Wicklung 3 ist eine Induktivität, die zusammen mit dem Kondensator 9 einen LC-Schwingkreis bildet. Der Spannungsimpuls wandelt sich so in eine periodisch abklingende Schwingung.

Der Zeitverlauf dieser Schwingung wird im Multimeter 1 mit dem Prozessor 19 und der Auswerteeinheit 20 ausgewertet. Hierzu wird im Spannungsmesspfad 17 die Impulsentladung erfasst und dem Komparator 18 und danach dem Prozessor 19 zugeführt. Über die Auswerteeinheit 20 wird die Zeitdauer 27 des ersten Schwingungsteils der gesamten Schwingung berechnet. Diese Zeitdauer 27 kann an der Anzeige 21 angezeigt oder in einem Speicher gespeichert werden.

Auf die beschriebene Art werden auch für die weiteren Wicklungen 5 und 6 des Elektromotors 4 die Zeitdauern 27 ermittelt.

Diese werden dann derart miteinander verglichen, dass die Differenzen ermittelt werden. Diese dürfen nur einen vorgegebenen Wert voneinander abweichen, ansonsten gilt eine der Wicklungen als defekt.

Kann man keine Zeitdauern mehrerer Prüflinge miteinander vergleichen, benötigt man Vorwissen, um die Zeitdauer 27 richtig bewerten zu können.

Grundsätzlich ist es möglich, ein Multimeter 1, das in Zusammenhang mit der Impulseinheit 2 eingesetzt wird, hard- und softwaremäßig derart herzurichten, dass das Multimeter 1 auf Eingabe eines Startimpulses eine erste Messung und nach einer weiteren Eingabe eines weiteren Startimpulses eine zweite und weitere Messungen durchführt.

Die Anzahl der Messungen kann im Display 21 angezeigt werden, die ermittelten Ergebnisse können z. B. in Mikrosekunden separat angezeigt werden und werden in einem Speicher des Multimeters 1 abgelegt.

Das Multimeter 1 ist in der Lage, auf die Speicherwerte einer Serie oder mehrerer Messserien zurückzugreifen und die größte Fehlerabweichung zwischen den einzelnen Messungen, die zunächst in Mikrosekunden angezeigt werden, als relativen Fehler anzuzeigen, was beispielsweise durch eine quasi analoge Bargraph-Anzeige geschehen kann. Selbstverständlich ist es auch möglich, auf andere Weise Fehlerabweichungen darzustellen, z. B. dadurch, dass alphanummerisch angezeigt wird, dass ein maximaler Messfehler bei der letzten Serie bei 10% lag.

Die Bedienungsperson hat dann die Möglichkeit mit einem Blick zu erkennen, ob gewisse Schwellenwerte bei einer Einzelmessung oder Serienmessung überschritten werden und ihre Schlüsse auf die Qualität des Einzelgerätes oder einer Geräteserie zu ziehen.

## Patentansprüche

1. Verfahren zur Ermittlung von Wicklungsfehlern in Elektrogeräten (4), **gekennzeichnet durch die Schritte:**
- Bereitstellen einer Spannung von wenigstens 500 V, insbesondere von wenigstens 1000 V, durch ein eine Hochspannungsquelle (16) umfassendes Multimeter (1),
- Anlegen dieser Spannung an den Eingang einer Impulseinheit (2) mit einer Kapazität, wodurch die Kapazität aufgeladen wird, und wobei die Kapazität mit einer Schaltfunkenstrecke (11) verbunden ist,
- Ausgabe wenigstens eines Spannungsimpulses durch die Schaltfunkenstrecke (11) auf den Ausgang (14, 15) der Impulseinheit (2),
- aufeinanderfolgendes Anlegen des Ausgangs (14, 15) der Impulseinheit (2) an wenigstens zwei Wicklungen (3, 5, 6) eines Elektrogeräts (4),
- Auswerten der Antwortsignale (24), die durch die Ausgabe des Spannungsimpulses jeweils entstehen, durch eine Auswerteeinheit (20), wobei zur Auswertung die Zeitdauer (27) des ersten negativen Schwingungsteils des Antwortsignals ermittelt wird, wobei das die Spannung bereitstellende Multimeter (1) zur Zeitmessung eingesetzt und die Zeitdauer (27) des ersten negativen Schwingungsteils in Mikrosekunden auf dem Display des Multimeters (1) angezeigt wird.

2. Verfahren nach Anspruch 1, **dadurch gekennzeichnet, dass** das Vorliegen eines Wicklungsfehlers in Abhängigkeit der Übereinstimmung eines Parameters der Antwortsignale (24) ermittelt wird.

3. Verfahren nach Anspruch 2, **dadurch gekennzeichnet, dass** ein Wicklungsfehler angezeigt wird, wenn die Differenz eines Parameters der ausgewerteten Antwortsignale (24), insbesondere der Zeitdauer einer Schwingung oder Halbschwingung, einen vorgegebenen Schwellenwert überschreitet oder von einem bereits ermittelten Vergleichswert mehr als einen vorgegebenen Wert abweicht.

4. Verfahren nach einem der vorangehenden Ansprüche, **dadurch gekennzeichnet, dass** als Kapazität ein Kondensator (9) verwendet wird.

5. Messaufbau zur Ermittlung von Wicklungsfehlern gemäß einem Verfahren nach einem der vorhergehenden Ansprüche, umfassend:
- ein eine Hochspannungsquelle (16) umfassendes Multimeter (1) sowie
- eine Impulseinheit (2) mit einer Kapazität und einer damit verbundenen Schaltfunkenstrecke (11), wobei die Kapazität mit einer Spannung aufladbar ist und mit der Schaltfunkenstrecke (11) bei Überschreiten einer Überschlagsspannung ein Spannungsimpuls ausgebbar ist.

6. Messaufbau nach Anspruch 5, **dadurch gekennzeichnet, dass** mit der Kapazität ein Entladewiderstand (10) parallel geschaltet ist.

7. Messaufbau nach Anspruch 5 oder 6, **dadurch gekennzeichnet, dass** die Impulseinheit (2) einen Schutzwiderstand (13) aufweist.

8. Messaufbau nach einem der Ansprüche 5 bis 7, **dadurch gekennzeichnet, dass** die Impulseinheit (2) wenigstens eine Sicherung (12) umfasst.

9. Messaufbau nach einem der Ansprüche 5 bis 8, **dadurch gekennzeichnet, dass** die Impulseinheit (2) als Ausgang wenigstens zwei Anschlüsse (14, 15) aufweist, mit denen die Impulseinheit (2) mit einer Wicklung (3, 5, 6) verbindbar ist.

10. Messaufbau nach einem der Ansprüche 5 bis 9, **dadurch gekennzeichnet, dass** die Impulseinheit (2) als Eingang wenigstens zwei Anschlüsse (7, 8) aufweist, mit denen die Impulseinheit (2) mit einer externen Vorrichtung, insbesondere einem Multimeter (1), verbindbar ist.

11. Messaufbau nach einem der Ansprüche 5 bis 10, **dadurch gekennzeichnet, dass** die Impulseinheit (2) Teil einer elektronischen Messeinrichtung, insbesondere eines Multimeters (1), ist.

## Claims

1. Method for determining winding faults in electrical appliances (4), **characterized by** the steps:
- a multimeter (1) comprising a high-voltage source (16) supplies a voltage of at least 500 V, in particular of at least 1000 V,
- said voltage is applied to the input of a pulse unit (2) having a capacitance, as a result of which the capacitance is charged, and wherein the capacitance is connected to a switching spark gap (11),
- at least one voltage pulse is emitted by the switching spark gap (11) to the output (14, 15) of the pulse unit (2),
- the output (14, 15) of the pulse unit (2) is successively applied to at least two windings (3, 5, 6) of an electrical appliance (4),
- an evaluation unit (20) evaluates the response signals (24) that arise in each case as a result of the emission of the voltage pulse, wherein, for the purpose of evaluation, the length (27) of the first negative part of the cycle of the response signal is determined, wherein the multimeter (1) that supplies the voltage is used for the purpose of time measurement and the length (27) of the first negative part of the cycle is indicated on the display of the multimeter (1) in microseconds.

2. Method according to Claim 1, **characterized in that** the presence of a winding fault is determined depending on the correspondence of a parameter of the response signals (24).

3. Method according to Claim 2, **characterized in that** a winding fault is indicated when the difference in a parameter of the evaluated response signals (24), in particular the length of a cycle or half-cycle, exceeds a prescribed threshold value or deviates from a comparison value that has already been determined by more than a prescribed value.

4. Method according to one of the preceding claims, **characterized in that** a capacitor (9) is used as the capacitance.

5. Test set-up [cf. page 4, line 1 of the original application documents] for determining winding faults in line with a method according to one of the preceding claims, comprising:
- a multimeter (1) comprising a high-voltage source (16) and
- a pulse unit (2) having a capacitance and a switching spark gap (11) connected thereto, wherein the capacitance can be charged with a voltage and a voltage pulse can be output using the switching spark gap (11) when a sparkover voltage is exceeded.

6. Test set-up according to Claim 5, **characterized in that** a discharge resistor (10) is connected in parallel with the capacitance.

7. Test set-up according to Claim 5 or 6, **characterized in that** the pulse unit (2) has a protective resistor (13).

8. Test set-up according to one of Claims 5 to 7, **characterized in that** the pulse unit (2) comprises at least one fuse (12).

9. Test set-up according to one of Claims 5 to 8, **characterized in that** the pulse unit (2) has, as the output, at least two connections (14, 15) that can be used to connect the pulse unit (2) to a winding (3, 5, 6) .

10. Test set-up according to one of Claims 5 to 9, **characterized in that** the pulse unit (2) has, as the input, at least two connections (7, 8) that can be used to connect the pulse unit (2) to an external apparatus, in particular a multimeter (1).

11. Test set-up according to one of Claims 5 to 10, **characterized in that** the pulse unit (2) is part of an electronic measuring device, in particular a multimeter (1).

## Revendications

1. Procédé de détermination d'erreurs d'enroulement dans des appareils électriques (4), **caractérisé par** les étapes consistant à :
- fournir une tension d'au moins 500 V, notamment d'au moins 1000 V, au moyen d'un multimètre (1) comprenant une source à haute tension (16),
- appliquer ladite tension à l'entrée d'une unité génératrice d'impulsions (2) comportant une capacité de manière à charger la capacité, et dans lequel la capacité est reliée à un éclateur (11),
- fournir en sortie au moins une impulsion de tension par l'intermédiaire de l'éclateur (11) à la sortie (14, 15) de l'unité génératrice d'impulsions (2),
- appliquer séquentiellement la sortie (14, 15) de l'unité génératrice d'impulsions (2) à au moins deux enroulements (3, 5, 6) d'un appareil électrique (4),
- évaluer les signaux de réponse (24) produits du fait de la fourniture en sortie de l'impulsion de tension, au moyen d'une unité d'évaluation (20), dans lequel la durée (27) de la première partie négative de l'oscillation du signal de réponse est déterminée aux fins de l'évaluation, dans lequel le multimètre (1) fournissant la tension est mis en oeuvre pour mesurer le temps, et la durée (27) de la première partie négative de l'oscillation est affichée en microsecondes sur l'afficheur du multimètre (1).

2. Procédé selon la revendication 1, **caractérisé en ce que** la présence d'une erreur d'enroulement est déterminée en fonction de la conformité d'un paramètre des signaux de réponse (24).

3. Procédé selon la revendication 2, **caractérisé en ce qu'**une erreur d'enroulement est affichée lorsque la différence entre un paramètre des signaux de réponse (24) évalués, notamment de la durée d'une oscillation ou d'une demi-oscillation, dépasse une valeur de seuil prédéterminée où s'écarte de plus d'une valeur prédéterminée d'une valeur de comparaison déjà déterminée.

4. Procédé selon l'une quelconque des revendications précédentes, **caractérisé en ce qu'**un condensateur (9) est utilisé en tant que capacité.

5. Structure de mesure [voir page 4, ligne 1 du dossier de notification original] destinée à déterminer des erreurs d'enroulement conformément à un procédé selon l'une quelconque des revendications précédentes, comprenant :
- un multimètre (1) comprenant une source à haute tension (16), et
- une unité génératrice d'impulsions (2) comportant une capacité et un éclateur (11) relié à celle-ci, dans lequel la capacité peut être chargée par une tension et une impulsion de tension peut être délivrée au moyen de l'éclateur (11) lorsqu'une tension de claquage est dépassée.

6. Structure de mesure selon la revendication 5, **caractérisée en ce qu'**une résistance de décharge (10) est connectée en parallèle à la capacité.

7. Structure de mesure selon la revendication 5 ou 6, **caractérisée en ce que** l'unité génératrice d'impulsions (2) comporte une résistance de protection (13).

8. Structure de mesure selon l'une quelconque des revendications 5 à 7, **caractérisée en ce que** l'unité génératrice d'impulsions (2) comprend au moins un dispositif de protection (12).

9. Structure de mesure selon l'une quelconque des revendications 5 à 8, **caractérisée en ce que** l'unité génératrice d'impulsions (2) comporte, en tant que sortie, au moins deux bornes (14, 15) à l'aide desquelles l'unité génératrice d'impulsions (2) peut être reliée à un enroulement (3, 5, 6).

10. Structure de mesure selon l'une quelconque des revendications 5 à 9, **caractérisée en ce que** l'unité génératrice d'impulsions (2) comporte, en tant qu'entrée, au moins deux bornes (7, 8) à l'aide desquelles l'unité génératrice d'impulsions (2) peut être reliée à un dispositif externe, en particulier un multimètre (1).

11. Structure de mesure selon l'une quelconque des revendications 5 à 10, **caractérisée en ce que** l'unité génératrice d'impulsions (2) fait partie d'un dispositif de mesure électronique, en particulier d'un multimètre (1).
